(19) Europäisches Patentamt
European Patent Office
Office européen des brevets

(11) Publication number: **0 134 943**
**B1**

# (12) EUROPEAN PATENT SPECIFICATION

(45) Date of publication of patent specification: **22.03.89**

(51) Int. Cl.$^4$: **G 01 R 29/08,** G 01 R 29/12

(21) Application number: **84107527.8**

(22) Date of filing: **29.06.84**

## (54) System and method for detecting proximity to electrical power lines.

(30) Priority: **25.07.83 CA 433141**

(43) Date of publication of application:
**27.03.85 Bulletin 85/13**

(45) Publication of the grant of the patent:
**22.03.89 Bulletin 89/12**

(84) Designated Contracting States:
**AT BE CH DE FR GB IT LI LU NL SE**

(56) References cited:
**AU-B- 502 946**
**GB-A-2 073 896**
**US-A-3 774 110**

**PATENT ABSTRACTS OF JAPAN, vol. 4, no. 131, 13th September 1980; & JP-A-55-82060 (RICOH K.K.) 20-06-1980**

(73) Proprietor: **HYDRO-QUEBEC**
**75, Boulevard Dorchester Ouest**
**Montréal Québec H2Z 1A4 (CA)**

(72) Inventor: **Cloutier, Marius**
**568 De Bienville**
**Boucherville Quebec (CA)**
Inventor: **Bourgeois, Jean-Marc**
**2843 Berthon**
**Longueuil Quebec (CA)**
Inventor: **Lalonde, François**
**140 Malo**
**Varennes Quebec (CA)**

(74) Representative: **Casalonga, Alain et al**
**BUREAU D.A. CASALONGA OFFICE JOSSE & PETIT Morassistrasse 8**
**D-8000 München 5 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 134 943 B1**

**Description**

The present invention is concerned with the detection of the proximity of an object to one or more high voltage power lines and more particularly relates to a system and a method to detect proximity to high power alternating current electrical lines. The invention provides a means of signalling to the operator of heavy equipment in the environment of such lines of the danger of a portion of the equipment being too close to such high voltage electrical lines.

Each year, an increasing number of workers are subjected to injuries, resulting in physical and psychological damage, from electrical shocks when an equipment that a person is operating or standing close to comes in contact or too close to a high power electrical line. Such is often the case when a crane or a vehicle having a boom is operating near such lines. In order to try to reduce this danger, various proximity detection systems or devices have been developed and used. Such systems or devices utilize circuits which operate on the principle of the measurement of equipotential voltages. It is known that an electrical field builds up about electrical power lines and the intensity of such field decreases along equipotential lines. The voltage of the field is measured and increases as the measuring device is displaced closer and closer to the electrical power line, the maximum intensity of the voltage being achieved when the measuring antenna touches the line. In the detection circuits heretofore known, the equipotential voltage which is received by the antenna is measured and compared to a known value and all measured voltages that are greater than the known value cause an alarm to be activated.

The Australian patent document AU—B—502 946 (Crane Products Manufacturing) discloses a proximity alarm system for detecting the close approach to an electrical transmission line using an antenna detecting the electrostatic field and issuing an output signal corresponding to a voltage induced in the antenna.

This signal is then applied to an oscillating circuit giving a succession of pulses which are finally enlarged and fed to a relay triggering an alarm.

One of the major disadvantages of such systems is that the voltage which is received by the antenna leans toward a limit value which is the line to ground voltage. Thus, in the presence of two electrical lines of different voltages, there is a risk of touching the line at the lowest voltage without activating the alarm. It is conceivable that the level of the voltage required to trigger the alarm of one of the lines, having the higher voltage, can be higher to the actual voltage on the other line. Also, it is pointed out that equipotential voltages are easily perturbed by neighboring metallic structures (i.e., steel towers). To all these inconveniences, there is also the difficulty of measuring equipotential voltages due to the requirement of very high impedance circuits.

It is a feature of the present invention to substantially overcome these inconveniences in the prior art and the present invention therefore provides a method and a system for detecting the proximity of an object to electrical AC power lines by measuring the capacitive current generated from a live electrical power line. For a given line, at a given voltage, the intensity of the capacitive current is a function of the distance between the receiving antenna device and the electrical power line. With such an arrangement we can therefore utilize the information to evaluate the distance between the line and the receiving antenna device.

The method of detection of the present invention provides an important improvement with respect to the method of measuring equipotential voltages for the reason that the intensity of the capacitive current increases rapidly as the distance between the receiving antenna device and the electrical line diminishes, and becomes theoretically infinite as the distance becomes null. By the method of the present invention, the threshold value indicating the value above which the danger of contacting the line exists, is always obtained regardless of the voltage on the electrical line. Furthermore, the principle of measuring the capacitive current considerably reduces the effects on the received signal caused by environmental structures. Finally, the circuits utilized with the present invention to measure the capacitive current do not require high impedance circuits.

As claimed the proximity alarm system of the present invention for giving warning when a projection from a vehicle or other object enters the electric field located around an energized alternating current power line, comprises a receiving antenna device adapted to be mounted on the projection, electrically connected to the input of a measuring and conditioning circuit delivering a coded signal which is a function of the distance between the antenna and the power line. An alarm circuit is further connected to the measuring and conditioning circuit to generate an alarm when the said signal reaches a predetermined value. According to the invention, the measuring and conditioning circuit ihas a low input impedance and is adapted for measuring the intensity of a current generated from the said power line in said receiving antenna device by capacitive effect.

As further claimed, the method of proximity detection of the present invention for giving a warning when a projection of an object enters the electric field located around an energized alternating current power line comprises the steps of:

—providing an antenna device on said projection for delivering a signal whose intensity is a function of the distance between the antenna and the power line;

—measuring and conditioning said signal and delivering a coded signal;

—comparing said coded signal with a predetermined value;

—and triggering an alarm if said coded signal reaches said predetermined value.

According to the invention,

—said signal delivered by the antenna device is proportional to the intensity of a current generated from said power line by capacitive effect.

The method further comprises the following steps:

—said intensity is measured;

—said measured intensity is conditionned to provide a coded signal for transmission to a master station;

—said coded signal is analyzed in said master code station to compare said coded signal to predetermine coded values;

—and said alarm is triggered if said coded signal contains information requiring an alarm to be triggered.

An example of the preferred embodiment of the present invention will now be described with reference to the accompanying drawings in which:

Figure 1 is a schematic illustration of a crane equipped with the proximity detector of the present invention in the surrounding of a power line;

Figure 2A is a graph diagram illustrating the signal curve of the prior art method of equipotential measurements as a function of the distance separating the receiver antenna device from the electrical power line;

Figure 2B is a graph showing the signal curve when measuring capacitive current as a function of the distance separating the receiver antenna device from the electrical power line;

Figure 3 is a schematic illustration showing the impedances of a metal dish utilized as a sensing device for measuring equipotential voltages and capacitive currents;

Figure 4 is a graph showing the curves of measured signals as a function of the distance d (Figure 1) between the receiver antenna device and the metallics boom for both equipotential measurement and capacitive current measurement;

Figure 5 is a block diagram of the measuring and conditioning circuit also herein known as a slave station; and

Figure 6 is a block diagram of a typical installation of the detection system of the present invention.

Referring now to Figure 1, there is illustrated very schematically the method of detecting the proximity to an electrical line 1 by capacitive current measurement. A crane 2 is positioned close to the electrical line 1 and is provided at the extremity of the boom 5 with a receiver antenna device 3 which is located a distance D from the electrical conductive power line 1 and at a distance d from the metallic boom 5. At a certain distance D from the electrical line 1, the voltage on the line induces in the receiver antenna device 3 a current of which the magnitude is measured by the use of the measuring and conditioning circuit in the slave station 4 which is located close to the receiving device 3. A master control station 6 is connected to the slave station 4 by a cable 7. This master control station 6 is also connected to alarm circuits (not shown) in order to provide an alarm to the operator when a danger situation exists and is further provided with a self-checking circuit to verify the proper operation of the slave station.

The combination of the electrical line and the receiver antenna device 3 forms a capacity C. This capacitor has a capacitance which is expressed by the following formula:

$$C=G'(D,d,s,\varepsilon_r,\Gamma_1,\Gamma_2)$$

where D is the distance between the electrical line 1 and the receiver antenna device 3, d is the distance between the receiver antenna device 3 and the metallic boom 5, s is the surface of the sensing device 3; $\varepsilon_r$ is the dielectric constant; $\Gamma_1$ is the effect from the line geometry; $\Gamma_2$ is the effect from the metallic structural geometry around the sensing device. In the present detection system, some of these parameters are fixed, others are voluntarily fixed, and some are negligible or made negligible by the measuring method utilized. The only significant parameter is thus the distance between the receiver antenna device 3 and the line 1, namely the distance D. Thus, we can simplify the formula as follows:

$$C=G(D)$$

This relation permits us to deduce that the current which is received in the receiver antenna device as an intensity $I_c$ which is a function of the distance D separating the receiver antenna device 3 from the line 1 and of the voltage V of the line. This can be expressed by the following equation:

$$I_c=(2\pi fV)C,\ C=G(D)$$

where C is the capacitance between the line and the receiver antenna device; D is the distance between the line and the receiver antenna device; $I_c$ is the capacitive current; f is the frequency of the voltage V of the electrical line.

The capacitive current measuring system of the present invention offers considerable advantages when compared to the prior art systems which are based on measuring equipotential voltages. Figure 2A is a graph illustration of measurements of equipotential voltage as a function of the distance between the receiver antenna device and the electrical line. This graph illustrates the signal voltage $V_c$ when the receiver antenna device is in the neighborhood of a 230kV electrical line or in the neighborhood of a 25kV electrical line. It can be seen that when a reference voltage has been established at a value of $V_1$ to trigger an alarm in order to limit the distance of the equipment to a value $D_1$ from the line, this reference voltage can be inoperative when utilized in proximity to a 25kV line as the reference voltage $V_1$ is at a level which is above the voltage of a 25kV line. This creates a very dangerous situation as the equipment can touch the 25kV line without an alarm having been triggered.

By measuring the capacitive current as with the present invention, such a danger situation is eliminated. Figure 2B illustrates the capacitive current $I_c$ of which the intensity is a function of the distance between the receiver antenna device and the electrical line and of the voltage of that line. This Figure illustrates the distribution of the intensity of the signal $I_c$ with respect to two particular electrical lines, namely a 230kV and a 25kV electrical lines. In this example, it can be seen that even if the reference point to trigger the alarm is fixed at a value $I_1$, in order to limit the boom of a vehicle within a distance $D_1$ in the case of a 230kV line, there will also be an alarm triggered within the displacement $D_2$ in the environment of a 25kV line even if the reference point has not been corrected for the operation in the environment of a 25kV line. Thus, an alarm will be triggered even if the distance $D_2$ is less than the required distance permissible with respect to a 25kV line.

An important feature of the present invention is that the capacitive current $I_c$ tends towards a theoretical infinite value and not a fixed value as is the case when measuring equipotential voltages. Accordingly, by measuring the capacitive current it is possible to improve means of detecting proximity to electrical lines.

The principle of the present invention where proximity to a line is determined by measuring the capacitive current, offers other important advantages when we consider the construction of the measuring and conditioning circuit utilized in the system. An important feature associated with this method resides in the value of the input impedance of the measuring circuit in the slave station. When measuring equipotential voltages, as is also the case with measuring voltages, a high impedance input circuit is required with respect to the source impedance. In the case of measuring equipotential voltages, the source impedance seen by the measuring system is very large, many hundreds of megohms. It is therefore extremely difficult to design a measuring system which is adequate to obtain such measurements. On the other hand, the measure of the capacitive currents necessitate the use of a very low input impedance circuit with respect to the source impedance and this is very advantageous.

Figure 3 is an illustration to demonstrate another advantage in measuring the capacitive current at a receiver antenna device. Figure 3 illustrates the electrical model of the effects caused by the presence of metallic structures on the signal present at the receiver antenna device 3, herein a metallic dish antenna. In order to obtain a reliable measure of the signal, to represent the distance between the receiver antenna 3 and the line 1, it is necessary to minimize capacitive and resistive leakages $C_F$ and $R_F$ which drain the signal towards ground via the metallic structures in the environment of the antenna 3. When measuring equipotential voltages, the input impedance $Z_i$ of a measuring circuit 8 is very high and the leakage will considerably affect the measurement, which measurement is thus unacceptable when there is a metallic structure in the environment of the receiving antenna. Knowing that the leakage capacity $C_F$ is a variable term which depends mainly on the position of the antenna with respect to the metallic structure, the measured equipotential voltage is highly dependent on the distance separating the receiver antenna from the metallic structure (i.e., the boom of a crane). However, when measuring capacitive currents, the input impedance $Z_i$ of the measuring circuit 8 is very low and the leakage to the metallic structure (such as a boom) is considerably reduced and thus does not measurably affect the measurement, rendering it more reliable.

Figure 4 illustrates clearly the reliability of the measuring signal when using the method of the present invention as compared with the method of the prior art where equipotential voltages are measured. The curve B illustrates the measuring signal when using the capacitive current method whereas the curve A illustrates the measuring signal when utilizing the equipotential voltage measuring method. It can be seen that the measurements of curve B are less perturbed by the presence of metallic structures. Another advantage of using this signal is therefore that the receiving antenna can be located closer to the metallic boom or metallic structure of a vehicle thus causing less inconvenience.

In the present invention, the input signal is processed in two different steps. Firstly, the capacitive current received by the antenna 3 is subjected to a series of conversions in a measuring and conditioning circuit 4 which is located close to the antenna 3 (see Figure 5). The final processing stage of the signal as well as the alarm triggering circuit are located in a master control station 6, as illustrated in Figure 6. This master control station is accessible to the operator of the vehicle and he is provided with controls such as at 15, to operate the system.

Referring to Figure 5, the slave station 4 is shown connected to the antenna 3 which receives the capacitive currents and is also connected to the master control station 6 via connecting cable 7. The slave station 4 has a current measuring circuit 8. The signal at the output of the circuit 8 is fed to a conditioning circuit 9 in order to obtain a measured signal via control circuit 10 and to convert the measured signal into a coded signal to be transmitted to the master control station 6. The control circuit 10 is provided with a microprocessor and associated connecting circuits, and controls the operation of the slave station 4 including the transmission of signals through cable 7. A self-checking circuit 11 works in conjunction with the control circuit 10 to assure the proper functioning of the sub-circuits of the slave station 4 as well as the proper operation of the antenna 3.

Figure 6 is a schematic block diagram illustrating a typical installation of a measuring system. As herein shown, a plurality of slave stations 4, herein 4A, 4B, 4C, are each provided with a

receiver antenna 3A, 3B, 3C, respectively, interconnected by a cable 7. These slave stations 4A, 4B, and 4C are connected along a boom or at various strategic locations of a heavy machine, such as a crane.

The detection system as illustrated in Figures 5 and 6 assists the operator of the vehicle in providing an aid for proximity evaluation of the vehicle to electrical lines.

The slave stations provide the measuring of the capacitive currents as well as the conditioning of the measured signals to make it reliable for the master control station. The first stage of the subcircuits in the slave station measures the capacitive currents over a dynamic range of approximately 100dB. This operation is effected by the automatic gain controlled current-voltage converter circuit 8. The converter 8 is operated by the control and command circuit 10 and is capable of measuring signals on a large dynamic range with the precision required for the system. In order to eliminate the effects of noise, the slave station contains filter circuits (not shown). Noise rejection is effected in three steps. Firstly, a filter is provided to filter the analog signals and is incorporated in the measuring circuit 8. Secondly, digital filters are provided in the control circuit 10. Thirdly, the conditioning circuit 9 and the control circuit 10 are synchronized to the frequency of the electrical line voltage. This synchronization helps to eliminate noise which are not synchronous to the line frequency. The self-checking circuit continuously verifies the operation of the slave stations and provides the operator with a signal when there is a defective condition in the circuit. In the case, as shown in Figure 5, this verification by the circuit 11 is effected from the antenna input 3 to the output cable 7. The verification of the antenna is effected by polarizing the antenna with a signal which is located outside the frequency band of the signals being measured, and this being done by the self-checking circuit 11. This way, a short circuit or an open circuit condition on the antenna is immediately detected. This signal also makes it possible to continuously check the working conditions of the rest of the system as the system must recognize the continuing presence of the vertification signal. The malfunction of the control circuit 10 is detected by the master control station 6.

At the master control station 6, the circuits therein are provided for the verification of the validity of the signals being transmitted by the slave stations. The master control station also effects the required signal manipulation and calculations in order to trigger the alarms, such as 14, when required. The master control station 6 consists primarily of a microprocessor and associated circuits. The signal on the input line 7 is, as previously described, a coded message containing information as to the functioning of the slave station as well as the measured signal corresponding to the capacitive current measured. The master control station can therefore make decisions as to the proper functioning of the slave stations, such as 4A to 4C, by analyzing the first part of the message containing the coded signal. If the functioning of the slave stations is good, the master control station will then utilize the second part of the message in order to evaluate proximity conditions of the crane as related to the electrical lines, and trigger an alarm 14, if necessary. If the operation of the slave stations is judged to be improper by the nature of the first part of the composite signal, the operator of the vehicle is notified by providing a particular indication on a control panel (not shown). The master control station can also command the slave stations in order to initiate verifications of the circuits or adjustments thereof, or any other necessary function.

Finally, in order to assure the reliability of the system, the master control station is also provided with a verification system (not shown).

Each time an equipment is utilized with the system of the present invention, the operator must firstly execute a simple procedure to set the system via manual controls at 15. Using the controls 15, the operator initiates memorization of reference capacitive current values. Those values are used to trigger alarms and to provide progressive relative indication of the proximity to electrical lines.

## Claims

1. A proximity alarm system for giving warning when a projection (5) from a vehicle (2) or other object enters the electric field located around an energized alternating current power line (1), comprising a receiving antenna device (3) adapted to be mounted on the projection (5), electrically connected to the input of a measuring and conditioning circuit delivering a coded signal which is a function of the distance between the antenna and the power line, and an alarm circuit connected to the measuring and conditioning circuit to generate an alarm when the said signal reaches a predetermined value, characterized in that the measuring and conditioning circuit has a low input impedance and is adapted for measuring the intensity of a current generated from the said power line in said receiving antenna device by capacitive effect.

2. A system according to claim 1 characterized in that said measuring and conditioning circuit has an automatic gain controlled current-voltage converter and conditioning and control circuits for transforming the said received current to said coded signal for transmission to a master control station (6) which is provided with said alarm means.

3. A system according to claim 2 characterized in that the said alarm means are connected to said master control station and wherein the said coded signal is compared with predetermined stored values.

4. A system according to claim 3 characterized in that said predetermined stored values are determined on request by the operator each time

an equipment, provided with said system, is located in a new environment of electrical lines.

5. A system as claimed in claim 2 characterized in that there is a plurality of slave stations (4A, 4B, 4C), each slave station having one of said receiving antenna devices to receive by the capacitive effect a current of which the intensity is a function of the distance separating the said receiver antenna device from an electrical line, and wherein a master control station (6) is connected to each of said slave stations by means of a connecting cable and wherein said master control station is provided with alarm means to trigger an alarm when commanded by said master control station.

6. A system as claimed in any of claims 2 to 5 characterized in that each said slave station is provided with a self-checking circuit which provides a continuous verification signal situated outside the frequency band of the signal measured by the receiver device and verified by the said master control station.

7. A method of proximity detection for giving a warning when a projection of an object enters the electric field located around an energized alternating current power line comprising the steps of:

—providing an antenna device on said projection for delivering a signal whose intensity is a function of the distance between the antenna and the power line;

—measuring and conditioning said signal and delivering a coded signal;

—comparing said coded signal with a predetermined value;

—and triggering an alarm if said coded signal reaches said predetermined value;

characterized in that:

—said signal delivered by the antenna device is proportional to the intensity of a current generated from said power line by capacitive effect;

—said intensity is measured;

—said measured intensity is conditioned to provide a coded signal for transmission to the master control station;

—said coded signal is analyzed in said master control station to compare said coded signal to predetermine coded values;

—and said alarm is triggered if said coded signal contains information requiring an alarm to be triggered.

8. A method as claimed in claim 7 characterized in that said capacitive current is measured at a low impedance.

9. A method as claimed in claim 7 or 8 characterized in that the operation of the system is continuously verified by means of a verification signal injected in the system, said verification signal being located outside the frequency band of the signal to be measured by the receiver antenna device.

10. A method as claimed in any of claims 7 to 9 characterized in that a plurality of a different signals are measured by means of a plurality of receiver antenna devices and measuring and conditioning circuits to provide a plurality of coded signals to be fed to said master control station.

11. A method as claimed in any of claims 7 to 10 characterized in that said master control station analyzes the coded signals whereby to determine the proper functioning of the system.

12. A method as claimed in any of claims 7 to 11 characterized in that said predetermined stored values are determined by selecting a working zone wherein said equipment is to be used and such signals are stored in memory in said master control station.

**Patentansprüche**

1. Annäherungsalarmsystem, um eine Warnung abzugeben, wenn ein Vorsprung (5) von einem Fahrzeug (2) oder ein anderer Gegenstand in das elektrische Feld gelangt, das rund um eine spannungsführende Wechselstrom - Starkstromleitung (1) angeordnet ist, wobei das System eine Empfangsantenneneinrichtung (3) enthält, die so ausgeführt ist, daß sie auf dem Vorsprung (5) befestigt werden kann, wobei sie elektrisch mit dem Eingang einer Meß- und Aufbereitungsstufe verbunden ist, die ein kodiertes Signal liefert, das eine Funktion des Abstands zwischen der Antenne und der Starkstromleitung ist, sowie eine Alarmstufe enthält, die mit der Meß- und Aufbereitungsstufe verbunden ist, um einen Alarm zu erzeugen, wenn das Signal einen vorgegebenen Wert erreicht, dadurch gekennzeichnet, daß die Meß- und Aufbereitungsstufe eine niedrige Eingangsimpedanz besitzt und so aufgebaut ist, um die Intensität eines Stroms zu messen, der von der Starkstromleitung in dem Empfangsantenneneinrichtung durch eine kapazitive Wirkung erzeugt wird.

2. System gemäß Anspruch 1, dadurch gekennzeichnet, daß die Meß- und Aufbereitungsstufe einen Strom/Spannungs - Umsetzer mit automatischer Verstärkungsregelung sowie Aufbereitungs- und Steuerstufen besitzt, um den empfangenen Strom in das kodierte Signal für die Übertragung zu einer Hauptsteuerstation (6) umzusetzen, die mit der Alarmeinrichtung ausgestattet ist.

3. System gemäß Anspruch 2, dadurch gekennzeichnet, daß die Alarmeinrichtung mit der Hauptsteuerstation verbunden ist, wobei das kodierte Signal mit vorgegebenen, gespeicherten Werten verglichen wird.

4. System gemäß Anspruch 3, dadurch gekennzeichnet, daß die vorgegebenen, gespeicherten Werte von der Bedienungsperson nach Bedarf jedesmal festgelegt werden, wenn ein Gerät, das mit diesem System ausgestattet ist, in einer neuen Umgebung von elektrischen Leitungen angeordnet wird.

5. System gemäß Anspruch 2, dadurch gekennzeichnet, daß eine Vielzahl von Unterstationen (4A, 4B, 4C) vorgesehen ist, wobei jede Unterstation eine Empfangsantenneneinrichtung besitzt, um durch die kapazitive Wirkung einen Strom zu empfangen, dessen Intensität eine Funktion des Abstands zwischen der Empfangsantenneneinrichtung und der elektrischen Leitung ist, wobei eine Hauptsteuerstation (6) mit jeder Unterstation durch ein Verbindungskabel verbunden ist, und wobei die Hauptsteuerstation mit einer Alarmeinrichtung versehen ist, um einen Alarm auszulösen, wenn dies von der Hauptsteuerstation befohlen wird.

6. System gemäß jedem der Ansprüche 2 bis 5, dadurch gekennzeichnet, daß jede Unterstation mit einer Selbstprüfstufe versehen ist, die ein dauerndes Prüfsignal liefert, das außerhalb des Frequenzbands des Signals liegt, das von der Empfangseinrichtung gemessen wird, und das von der Hauptsteuerstation überprüft wird.

7. Verfahren zur Annäherungsabtastung, um eine Warnung abzugeben, wenn ein Vorsprung eines Gegenstandes in das elektrisches Feld gelangt, das rund um eine spannungsführende Wechselstrom - Starkstromleitung angeordnet ist, wobei das Verfahren folgende Schritte enthält:

Vorsehen einer Antenneneinrichtung auf dem Vorsprung, um ein Signal zu liefern, dessen Intensität eine Funktion des Abstands der Antenne und der Starkstromleitung ist;

Messen und Aufbereiten des Signals sowie Liefern eines kodierten Signals;

Vergleichen des kodierten Signals mit einem vorgegebenen Wert; und

Auslösen eines Alarms, wenn das kodierte Signal den vorgegebenen Wert erreicht;

dadurch gekennzeichnet, daß

das von der Antenneneinrichtung gelieferte Signal proportional der Intensität eines Stroms ist, der von der Starkstromleitung durch eine kapazitive Wirkung erzeugt wird;

die Intensität gemessen wird;

die gemessene Intensität aufbereitet wird, um ein kodiertes Signal für eine Übertragung zu der Hauptsteuerstation zu liefern;

das kodierte Signal in der Hauptsteuerstation analysiert wird, um das kodierte Signal mit vorgegebenen, kodierten Werten zu vergleichen; und

der Alarm ausgelöst wird, wenn das kodierte Signal eine Information enthält, die eine Alarmauslösung erfordert.

8. Verfahren gemäß Anspruch 7, dadurch gekennzeichnet, daß der kapazitive Strom an einer niedrigen Impedanz gemessen wird.

9. Verfahren gemäß Anspruch 7 oder 8, dadurch gekennzeichnet, daß die Arbeitsweise des Systems laufend mit Hilfe eines Prüfsignals überprüft wird, das in das System eingeleitet wird, wobei das Prüfsignal außerhalb des Frequenzbands des Signals angeordnet ist, das von der Empfangsantenneneinrichtung gemessen werden soll.

10. Verfahren gemäß jedem der Ansprüche 7 bis 9, dadurch gekennzeichnet, daß eine Vielzahl von unterschiedlichen Signalen von einer Vielzahl von Empfangsantenneneinrichtungen sowie Meß- und Aufbereitungsstufen gemessen wird, um eine Vielzahl von kodierten Signalen zu liefern, die an die Hauptsteuerstation gelegt werden.

11. Verfahren gemäß jedem der Ansprüche 7 bis 10, dadurch gekennzeichnet, daß die Hauptsteuerstation die kodierten Signale analysiert, um dadurch die richtige Arbeitsweise des Systems festzustellen.

12. Verfahren gemäß jedem der Ansprüche 7 bis 11, dadurch gekennzeichnet, daß die vorgegebenen, gespeicherten Werte durch die Auswahl eines Arbeitsbereichs festgelegt werden, in dem das Gerät verwendet werden soll und diese Signale in einem Speicher in der Hauptsteuerstation gespeichert werden.

**Revendications**

1. Système d'alarme de proximité pour donner une alarme lorsqu'une saillie (5) d'un véhicule (2) ou un autre objet entrent dans le champ électrique situé autour d'une ligne d'alimentation en courant alternatif sous tension (1) comportant un dispositif d'antenne réceptrice (3) adapté pour être monté sur la saillie (5), électriquement connecté à l'entrée d'un circuit de mesure et de conditionnement délivrant un signal codé qui est une fonction de la distance entre l'antenne et la ligne d'alimentation, et un circuit d'alarme connecté au circuit de mesure et de conditionnement de façon à générer une alarme lorsque ledit signal atteint une valeur prédéterminée, caractérisé en ce que le circuit de mesure et de conditionnement a une faible impédance d'entrée et est adapté pour mesurer l'intensité d'un courant généré par ladite ligne d'alimentation dans ledit dispositif d'antenne réceptrice par effet capacitif.

2. Système selon la revendication 1, caractérisé en ce que ledit circuit de mesure et de conditionnement possède un convertisseur courant-tension commandé par gain automatique et des circuits de commande et de conditionnement pour transformer ledit courant reçu en lesdits signaux codés pour la transmission à un poste de commande maître (6) qui est muni desdits moyens d'alarme.

3. Système selon la revendication 2, caractérisé en ce que lesdits moyens d'alarme sont connectés audit poste de commande maître et dans lequel ledit signal codé est comparé avec des valeurs mémorisées prédéterminées.

4. Système selon la revendication 3, caractérisé en ce que lesdites valeurs mémorisées prédéterminées sont déterminées à la demande par l'opérateur à chaque fois qu'un équipement, muni dudit système, est situé dans un nouvel environnement de lignes électriques.

5. Système selon la revendication 2, caractérisé en ce qu'il y a une pluralité de postes esclaves (4A, 4B, 4C), chaque poste esclave possédant un desdits dispositifs d'antenne réceptrice afin de recevoir, par effet capacitif, un courant dont l'intensité est une fonction de la distance séparant ledit dispositif d'antenne réceptrice d'une ligne électrique, et dans lequel un poste de commande maître (6) est connecté à chacun desdits postes esclaves au moyen d'un câble de connexion et dans lequel ledit poste de commande maître est muni de moyens d'alarme pour déclencher une

alarme lorsque l'ordre leur en est donné par ledit poste de commande maître.

6. Système selon l'une quelconque des revendications 2 à 5, caractérisé en ce que chacun desdits postes esclaves est muni d'un circuit à autocontrôle qui délivre un signal de vérification continue situé en dehors de la bande de fréquence du signal mesuré par le dispositif récepteur et vérifié par ledit poste de commande maître.

7. Procédé de détection de proximité pour donner une alarme lorsqu'une saillie d'un objet entre dans le champ électrique situé autour d'une ligne d'alimentation en courant alternatif sous tension, comportant les étapes suivantes:

—on installe un dispositif d'antenne sur ladite saillie pour délivrer un signal dont l'intensité est une fonction de la distance entre l'antenne et la ligne d'alimentation;

—on mesure et on conditionne ledit signal et on délivre un signal codé;

—on compare ledit signal codé avec une valeur prédéterminée;

—et on déclenche une alarme si ledit signal codé atteint ladite valeur prédéterminée;

caractérisé en ce que:

—ledit signal délivré par le dispositif d'antenne est proportionnel à l'intensité d'un courant généré à partir de ladite ligne d'alimentation par effet capacitif;

—ladite intensité est mesurée;

—ladite intensité mesurée est conditionnée pour délivrer un signal codé pour la transmission ou poste du commande maître;

—ledit signal codé est analysé dans ledit poste de commande maître pour comparer ledit signal codé à des valeurs codées prédéterminées;

—et ladite alarme est déclenchée si ledit signal codé contient une information nécessitant le déclenchement d'une alarme.

8. Procédé selon la revendication 7, caractérisé en ce que ledit courant capacitif est mesuré avec une faible impédance.

9. Procédé selon la revendication 7 ou 8, caractérisé en ce que le fonctionnement du système est continuellement vérifié au moyen d'un signal de vérification injecté dans le système, ledit signal de vérification étant situé à l'extérieur de la bande de fréquence du signal devant être mesuré par le dispositif d'antenne réceptrice.

10. Procédé selon l'une quelconque des revendications 7 à 9, caractérisé en ce qu'un pluralité de signaux différents sont mesurés au moyen d'une pluralité de dispositifs d'antenne réceptrice et de circuit de mesure et de conditionnement afin de délivrer une pluralité de signaux codés devant être délivrés audit poste de commande maître.

11. Procédé selon l'une quelconque des revendications 7 à 10, caractérisé en ce que ledit poste de commande maître analyse les signaux codés afin de déterminer ainsi le fonctionnement correct du système.

12. Procédé selon l'une quelconque des revendications 7 à 11, caractérisé en ce que lesdites valeurs mémorisées prédéterminées sont déterminées en sélectionnant une zone de travail dans laquelle ledit équipement doit être utilisé et les signaux sont stockés en mémoire dans ledit poste de commande maître.

Fig. 1

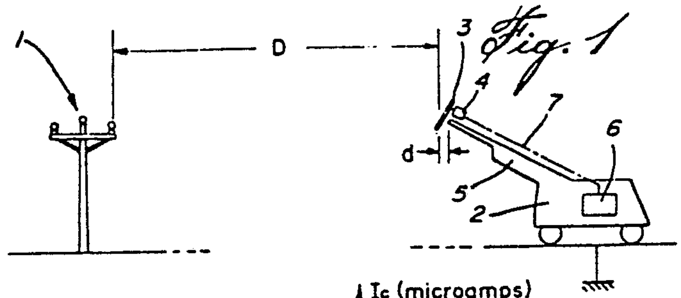


Fig. 2a
(PRIOR ART)

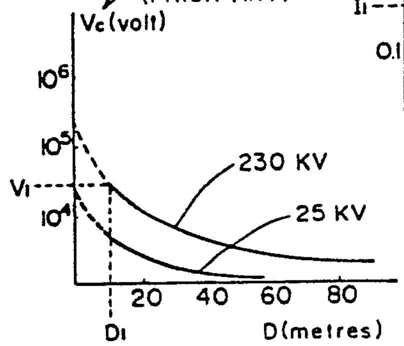


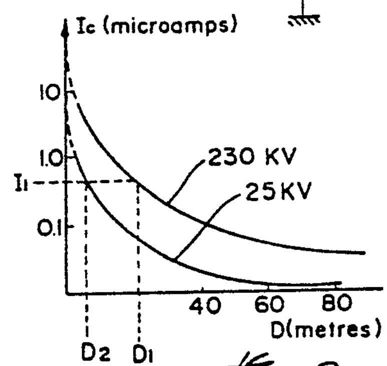


Fig. 2b

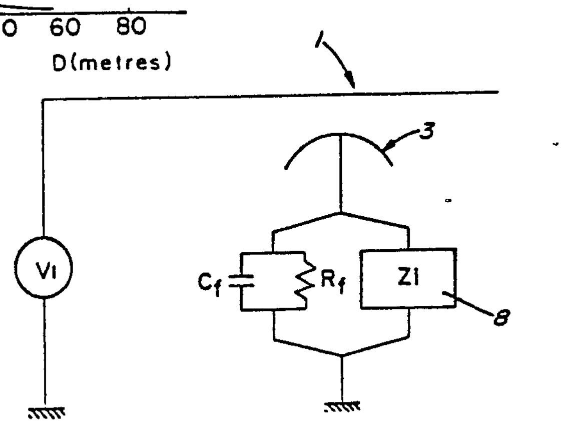


Fig. 3

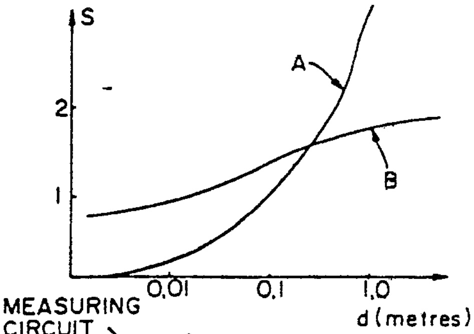


Fig. 4

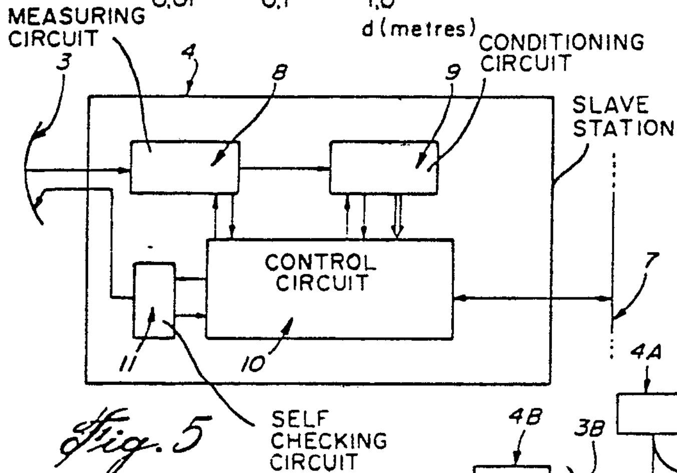


Fig. 5

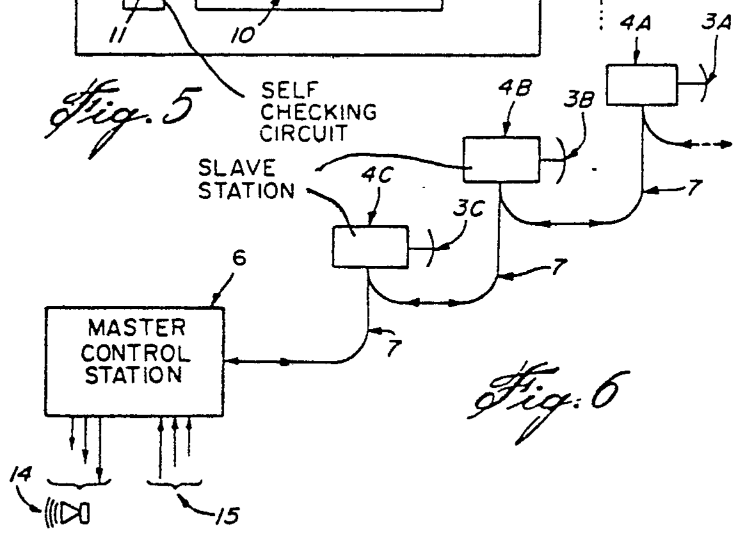


Fig. 6